(19) Europäisches Patentamt
European Patent Office
Office européen des brevets

(11) **EP 0 884 651 A2**

(12) **EUROPÄISCHE PATENTANMELDUNG**

(43) Veröffentlichungstag:
16.12.1998 Patentblatt 1998/51

(51) Int. Cl.⁶: **G03F 7/20**

(21) Anmeldenummer: 98108864.4

(22) Anmeldetag: 15.05.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 12.06.1997 DE 19724903

(71) Anmelder:
• **Carl Zeiss**
**D-89518 Heidenheim (Brenz) (DE)**
Benannte Vertragsstaaten:
**DE FR IT NL**
• **CARL-ZEISS-STIFTUNG, trading as CARL ZEISS**
**89518 Heidenheim (DE)**
Benannte Vertragsstaaten:
**GB**

(72) Erfinder: **Bader, Dieter**
**73527 Schwäbisch Gmünd (DE)**

(54) **Lichtintensitätmessanordnung**

(57) Lichtintensitätsmeßanordnung in einem Beleuchtungssystem einer Projektionsbelichtungsanlage für die Mikrolithographie bei der

- ein lichtmischender Glasstab (41, 42) vorgesehen ist,

-- in dem ein Umlenkspiegel (5) vorgesehen ist,

--- welcher einen Bruchteil der Lichtintensität transmittiert: und

- ein Energiesensor (6) angeordnet ist, der den transmittierten Bruchteil der Lichtintensität erfaßt; und
- eine verstellbare Blende (7) in Lichtflußrichtung nach dem Glasstab (41, 42) angeordnet ist,

-- welche Licht in den Glasstab (41, 42) zurück reflektiert, das zu Teilen auch zum Energiesensor (6) gelangt und

- ein Kompensationsdetektor (8), enthaltend

-- einen Photodetektor (81), am Umlenkspiegel (5) in der Hauptrichtung des von der verstellbaren Blende (7) reflektierten Lichts angeordnet ist.

**Beschreibung**

Die Erfindung betrifft eine Lichtintensitätsmeßanordnung nach dem Oberbegriff des Anspruchs 1.

Derartige Anordnungen sind in Wafer-Steppern bzw. Scannern der Firma ASM-L mit Optiken der Firma Carl Zeiss, Oberkochen, Deutschland, in Gebrauch. WO 97/31298 ist eine Veröffentlichung dazu, die auch eine Lichtintensitätsmeßanordnung nach dem Oberbegriff des Anspruchs 6 betrifft. Derartige Anordnungen sind auch aus EP 0 500 393 B1 (Fig. 13) bekannt.

Die Messung der Lichtintensität - und damit der Energie nach zeitlicher Integration - dient der präzisen Belichtung des Photolacks, aber auch als Eingangsgröße für Regelkreise, mit denen Einflüsse des Lichtflusses auf die optischen Elemente (lens heating, thermische Linse) stabilisiert werden.

Mit zunehmender Genauigkeitsanforderung des gesamten Belichtungssystems und -vorgangs und mit zunehmender Variabilität des ganzen Systems, insbesondere mit veränderlicher Einstellung einer Retikel-Maskierungsblende am Ausgang des Glasstabs, deren Blendenlamellen erheblich zurück in den Glasstab reflektieren, ergeben sich hierbei Probleme mit der Meßgenauigkeit.

Aufgabe der Erfindung ist die Bereitstellung einer derartigen Anordnung mit verbesserter Meßgenauigkeit bei größerer Flexibilität der Einstellungen des Beleuchtungssystems.

Diese Aufgabe wird gelöst durch die Einführung eines Kompensationsdetektors gemäß den kennzeichnenden Merkmalen des Anspruchs 1.

Vorteilhafte Ausführungsformen sind Gegenstand der Ansprüche 2 bis 5. Anspruch 6 gibt ebenfalls die Lösung der Aufgabe nach dem gleichen Prinzip wie Anspruch 1 an.

Näher erläutert wird die Erfindung anhand der Zeichnung:

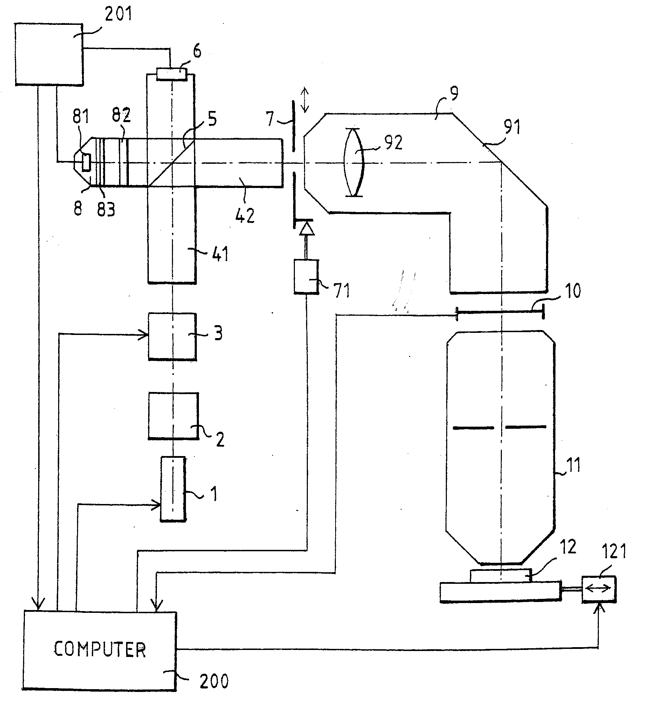

Figur 1    zeigt eine schematische Übersicht über eine Mikrolithographie-Projektionsbelichtungsanlage mit erfindungsgemäßer Lichtintensitätsmeßanordnung.

Die in der Figur 1 gezeigte Mikrolithographie-Projektionsbelichtungsanlage hat einen Excimer-Laser 1 als DUV-Lichtquelle. Eine Spiegelanordnung 2 dient der Kohärenzreduktion und Strahlformung. Das Zoom-Axicon-Objektiv 3 ermöglicht die verlustarme Einstellung von klassischen und Ringapertur-Beleuchtungen mit verschiedenem Kohärenzgrad. Ein Glasstab mit den zwei Teilstücken 41, 42 und dem Umlenkspiegel 5 (dieser ist aus Gründen der Geometrie der ganzen Anlage hier vorgesehen) dient der Homogenisierung der Ausleuchtung. Daran schließt sich die verstellbare Retikel-Maskierblende 7 mit dem Stelltrieb 71 an. Das REMA-Objektiv 9 bildet die Öffnung der Retikel-Maskierblende 7 randscharf auf das Retikel 10 ab, so daß genau der auf den Wafer 12 zu übertragende Bereich der Maske auf dem Retikel 10 ausgeleuchtet wird. Das Projektionsobjektiv 11 bildet die Maske auf dem Retikel 10 verkleinert auf dem Wafer 12 ab.

Auch im REMA-Objektiv 9 ist ein Umlenkspiegel 91 vorgesehen, um die Abmessungen der Apparatur den Anforderungen anzupassen. Stellvertretend ist eine Linse 92 gezeigt.

Der Spiegel 5 ist teildurchlässig ausgeführt, vorzugsweise weist er kleine Löcher in der Verspiegelung auf. Ein kleiner Bruchteil des Laserlichts wird so dem Energiesensor 6 zugeführt, einer Photodiode. Schwankungen der Leistung des Lasers 1 können so erfaßt und die Belichtungszeit des Wafers 12 kann optimal gesteuert werden.

Die Anforderungen an die Retikel-Maskierblende 7, die variablen Durchlaßquerschnitt bei stets sehr präzise in einer Ebene liegenden Rand aufweisen muß und möglichst nahe am Auslaßende des Glasstabs 41, 42 angeordnet ist, bringen es mit sich, daß sie im DUV-Licht eine erhebliche Reflektivität (ca. 65 %) aufweist und erhebliches Reflexlicht zurück zum teildurchlässigen Spiegel 5 gelangt. Streulicht gelangt deshalb auch in den Energiesensor 6 und verfälscht dessen Anzeige. Es ist jedoch eine Meßgenauigkeit von unter 5 Promille, vorzugsweise 1 bis 2 Promille und besser gefordert.

Erfindungsgemäß wird daher in Verlängerung des ausgangsseitigen Teils 42 des Glasstabs hinter dem teildurchlässigen Spiegel 5 ein Kompensationsdetektor 8 angeordnet. Dessen Photodetektor 81 ist ein Filterpaket 83 (BG-UG-Filter) vorgeschaltet, welches Störstrahlung absorbiert, und optional eine Streuscheibe 82, welche dazu dient, die radiale Intensitätsverteilung des Reflexlichts von der Stellung der Retikel-Maskierblende 7 unabhängig zu machen. Daneben ist die Ausführung des Kompensationsdetektors 8 als Lichtfalle für das DUV-Licht vorgesehen, mit entsprechend nicht-reflektierenden Flächen in einer Geometrie, die die Reflexion zurück zum Spiegel 5 und zum Energiesensor 6 verhindert.

Eine Recheneinheit 201 kann jetzt vom Roh-Meßwert "es" des Energiesensors 6 den Störanteil "el x k" des Reflexlichts subtrahieren. Dieser ergibt sich aus dem Meßwert "el" des Photodetektors 81 multipliziert mit dem Kalibrierfaktor "k".

Zur Bestimmung des Kalibrierfaktors "k" werden bei einer bestimmten Stellung der Retikel-Maskierblende 7, vorzugsweise bei engster Stellung, also maximaler Überdeckung des Glasstab-Querschnitts von z.B. 60 % oder 72 % und somit bei maximalem Reflexlicht, "es$_{72}$" und "el$_{72}$" bestimmt und wird hinter der Retikel-Maskierblende ein Absolutwert "ss" erfaßt. Das selbe wird bei größter Öffnung der Retikel-Maskierblende 7 - Überdeckung 0 % - ausgeführt.

Der Absolutwert "ss" wird mit einem Photodetektor (Spotsensor) vermessen (in der Zeichnung nicht dargestellt), der hinter der Retikel-Maskierblende 7 das gesamte Lichtbündel erfaßt. Beim Aufbau des Beleuchtungssystems kann er direkt hinter die Retikel-Maskierblende gestellt werden. Zur Überprüfung im Betrieb kann ein solcher Sensor z.B. in die Ebene des Retikels 10 oder des Wafers 12 eingeführt werden.

Der Kalibrierfaktor ergibt sich dann zu

$$k = ((es_{72} - es_0) - (ss_{72} - ss_0) / (el_{72} - el_0).$$

Vorzugsweise werden für die verschiedenen Einstellungen des Zoom-Axicon-Objektivs 3, entsprechend verschiedenen Beleuchtungsaperturen bzw. Kohärenzgraden σ bei klassischer oder Ringaperturbeleuchtung, eigene Kalibrierfaktoren "k" bestimmt.

Es sind auch andere Korrekturverfahren möglich, wenn mehr Stützstellen mit Absolutwerten "ss" gemessen werden. Dann kann z.B. auch eine look-up-table eingerichtet und ausgewertet werden.

Die korrigierten Meßwerte der Recheneinheit 201 werden an den Computer 200 weitergegeben, der die ganze Anlage steuert und u.a. die Belichtungszeit regelt und die Stellungen der Retikel-Maskierblende 7, des Retikels 10 und des Wafers 12 mit Verstelleinheit 121 bestimmt.

Natürlich kann die erfindungsgemäße Belichtungsmessung in allen Ausführungen von Projektionsbelichtungsanlagen mit den Merkmalen des Anspruchs 1 oder 6 angeordnet werden.

**Patentansprüche**

1. Lichtintensitätsmeßanordnung in einem Beleuchtungssystem einer Projektionsbelichtungsanlage für die Mikrolithographie bei der

 - ein lichtmischender Glasstab (41, 42) vorgesehen ist,

   -- in dem ein Umlenkspiegel (5) vorgesehen ist,

     --- welcher einen Bruchteil der Lichtintensität transmittiert; und

 - ein Energiesensor (6) angeordnet ist, der den transmittierten Bruchteil der Lichtintensität erfaßt; und
 - eine verstellbare Blende (7) in Lichtflußrichtung nach dem Glasstab (41, 42) angeordnet ist,

   -- welche Licht in den Glasstab (41, 42) zurück reflektiert, das zu Teilen auch zum Energiesensor (6) gelangt,

   dadurch gekennzeichnet, daß
 - ein Kompensationsdetektor (8), enthaltend

   -- einen Photodetektor (81), zur Erfassung des von der verstellbaren Blende (7) reflektierten Lichts angeordnet ist.

2. Lichtintensitätsmeßanordnung nach Anspruch 1, dadurch gekennzeichnet, daß der Kompensationsdetektor (8) vor dem Photodetektor (81) eine Streuscheibe (82) enthält.

3. Lichtintensitätsmeßanordnung nach Anspruch 1 oder 2, dadurch gekennzeichnet, daß der Kompensationsdetektor (8) vor dem Photodetektor (81) ein Filter (83) enthält.

4. Lichtintensitätsmeßanordnung nach mindestens einem der Ansprüche 1 bis 3, dadurch gekennzeichnet, daß der Kompensationsdetektor (8) als Lichtfalle ausgebildet ist.

5. Lichtintensitätsmeßanordnung nach mindestens einem der Ansprüche 1 bis 4, dadurch gekennzeichnet, daß der Kompensationsdetektor (8) am Umlenkspiegel (5) in der Hauptrichtung des von der verstellbaren Blende (7) reflektierten Lichts angeordnet ist.

6. Lichtintensitätsmeßanordnung in einem Beleuchtungssystem einer Projektionsbelichtungsanlage für die Mikrolithographie bei der

 - ein Umlenkspiegel (5) vorgesehen ist,

   -- welcher einen Bruchteil der Lichtintensität,

 - einem Energiesensor (6) zuführt; und
 - eine verstellbare Blende (7) in Lichtflußrichtung nach dem Umlenkspiegel (5) angeordnet ist,

   -- welche Licht zu dem Umlenkspiegel (5) zurück reflektiert, das zu Teilen, insbesondere als Streulicht, auch zum Energiesensor (6) gelangt,

   dadurch gekennzeichnet, daß
 - ein Kompensationsdetektor (8), enthaltend

   -- einen Photodetektor (81), zur Erfassung des von der verstellbaren Blende (7) reflektierten Lichts angeordnet ist.